# EUROPÄISCHE PATENTANMELDUNG

(11) **EP 2 736 070 A1**
(43) Veröffentlichungstag der Anmeldung: **28.05.2014**
(21) Anmeldenummer: 12194373.2
(22) Anmeldetag: 27.11.2012
(51) Int. Cl.: H01L 21/673, H01L 21/67

(54) **Gefäß zur einseitigen Bearbeitung eines Substrats**

(71) Anmelder: Rheinisch-Westfälisch-Technische Hochschule Aachen, 52056 Aachen (DE)
(72) Erfinder: De Doncker, Rik W.A.A. Dr. ir., B-3000 Leuven (BE); Butschen, Thomas, D-41751 Viersen (DE)
(74) Vertreter: Raasch, Detlef

(57) **Zusammenfassung**

Die Erfindung bezieht sich auf ein Gefäß (1) zur einseitigen Bearbeitung eines Substrats (2) und ein entsprechendes Verfahren. Dazu umfasst das Gefäß (1) ein Gefäßunterteil (11) und ein auf dem Gefäßunterteil (11) zur Halterung des Substrates (2) angeordneten Gefäßoberteil (12), wobei das Gefäßoberteil ein Oberteilvolumen (122) zur Aufnahme einer oberflächenangreifenden Flüssigkeit (3) zur Bearbeitung des Substrats umfasst, die über mindestens eine Einfüllöffnung (123) im Gefäßoberteil in das Oberteilvolumen (122) eingelassen werden kann (12), wobei das Gefäßunterteil (11) auf der dem Gefäßoberteil (12) zugewandten Seite (110) eine für das Substrat (2) geeignet angepasste erste Auflagefläche (111) umfasst und das Gefäßoberteil (12) auf der dem Gefäßunterteil (11) zugewandten Seite (12u) eine für das Substrat (2) geeignet angepasste zweite Auflagefläche (121) umfasst, wobei die ersten und zweiten Auflageflächen (111, 121) und die Formen des Gefäßunterteils (11) und des Gefäßoberteils (12) so ausgestaltet sind, dass das zwischen den ersten und zweiten Auflageflächen (111, 121) positionierte Substrat (2) flüssigkeitsdicht gehaltert (H) werden kann, so dass die oberflächenangreifenden Flüssigkeit (3) nicht von der zu bearbeitenden Seite (21) des Substrats (2) auf eine andere Seite (22) des Substrats (2) gelangen kann und das Oberteilvolumen eine ausreichende Größe besitzt, um eine für die Bearbeitung benötigte Menge der oberflächenangreifenden Flüssigkeit (3) aufzunehmen und während der Bearbeitung (BA) des Substrats (2) zu speichern (S), wobei eine untere Grenze des Oberteilvolumen (122) durch die zu bearbeitende Seite (21) des Substrats (2) gebildet wird. Mit dem erfindungsgemäßen Gefäß wird eine einseitige Bearbeitung eines Substrats mit einer verringerten Menge an oberflächenangreifender Flüssigkeit ermöglicht, wobei die Vorrichtung leicht und sicher zu handhaben ist und mit weniger Aufwand und zu geringeren Materialkosten gefertigt werden kann.

## Beschreibung

### Gebiet der Erfindung

Die Erfindung betrifft ein Gefäß zur einseitigen Bearbeitung eines Substrats und ein entsprechendes Verfahren.

### Hintergrund der Erfindung

In der Mikrosystemtechnik wird nasschemisch geätzt oder gereinigt. Durch die Prozessfolge kann es manchmal notwendig sein, ein Substrat (beispielsweise einen sogenannten Wafer) nur einseitig nasschemisch zu bearbeiten. Dazu muss einerseits die Seite, die bearbeitet werden soll, mit der nasschemischen Flüssigkeit in Berührung gebracht werden und andererseits die Seite, die nicht bearbeitet werden soll, vor der nasschemischen Flüssigkeit geschützt werden. Dazu muss die nicht zu bearbeitende Seite eingekapselt werden.

US 5,324,410 beschreibt eine solche Einkapselung eines zu bearbeitenden Substrats (Silizium-Wafer) aus einem Bodenteil und einem ringförmigen Deckel, zwischen denen das Substrat auf jeweilige O-Ringe positioniert wird. Das Bodenteil ist hermetisch geschlossen. Deckel und Bodenteil besitzen Schraubenlöcher, in die Feststellschrauben eingesetzt werden können, so dass Deckel und Bodenteil auseinander gepresst werden können. Aufgrund des so ausgeübten Drucks dichten die O-Ringe die dem Bodenteil zugewandte Seite des Substrats flüssigkeitsdicht ab. Für den Ätzprozess (Bearbeitung) wird die Einkapselung anschließend in ein Ätzbad gelegt, so dass die Ätzflüssigkeit die Einkapselung bedeckt und durch die Öffnung des ringförmigen Deckels auf die Oberseite des Substrats zur Bearbeitung dieser Seite fließen kann. Damit die Einkapselung die andere Seite des Substrats zuverlässig vor der Ätzflüssigkeit schützen kann, müssen alle Bestandteile der Einkapselung aus einem gegenüber der Ätzflüssigkeit chemisch resistenten Material gefertigt sein. Solche Materialien sind teurer als weniger oder nicht beständige Materialien, was die Materialkosten für die Einkapselung erhöhe. Zusätzlich wird für den Ätzvorgang ein Ätzbad benötigt, dass groß genug ist, die Einkapselung aufnehmen zu können. Entsprechend groß ist auch die benötigte Menge an Ätzflüssigkeit, die in das Ätzbad gefüllt werden muss, um eine Bearbeitung des Substrats sicherstellen zu können. Eine Verringerung des Materialbedarfs an Ätzflüssigkeit pro Ätzvorgang wäre dagegen wünschenswert. Beim Entfernen der Einkapselung zur Beendigung des Ätzvorgangs aus dem Ätzbad müssen zudem Sicherheitsmaßnahmen getroffen werden, damit nicht Teile der Ätzflüssigkeit von der Einkapselung in Bereiche oder in Kontakt mit dem Bedienpersonal gelangen können, wo dieser Kontakt ein Sicherheitsrisiko oder eine Gefährdung der Gesundheit des Personals darstellen könnte. Dadurch wird der Prozessaufwand erhöht. Zur Vermeidung von Überdrücken innerhalb des eingekapselten Volumens während des Ätzvorgangs aufgrund von Temperaturerhöhungen besitzt die offenbarte Einkapselung einen aufwendig gearbeiteten Kanal zur Umgebungsluft hin, der gegenüber der Ätzflüssigkeit speziell abgeschirmt ist. Eine weniger aufwändige Konstruktion der Einkapselung wäre wünschenswert.

### Zusammenfassung der Erfindung

Es ist daher eine Aufgabe der Erfindung, eine Vorrichtung zur Verfügung zu stellen, mit der eine einseitige Bearbeitung eines Substrats mit einer verringerten Menge an oberflächenangreifender Flüssigkeit ermöglicht und wobei die Vorrichtung leicht und sicher zu handhaben ist und mit weniger Aufwand und zu geringeren Materialkosten gefertigt werden kann.

Diese Aufgabe wird gelöst durch ein Gefäß zur einseitigen Bearbeitung eines Substrats mit einem Gefäßunterteil und einem auf dem Gefäßunterteil zur Halterung des Substrates angeordneten Gefäßoberteil, wobei das Gefäßoberteil ein Oberteilvolumen zur Aufnahme einer oberflächenangreifenden Flüssigkeit zur Bearbeitung des Substrats umfasst, die über mindestens eine Einfüllöffnung im Gefäßoberteil in das Oberteilvolumen eingelassen werden kann, wobei das Gefäßunterteil auf der dem Gefäßoberteil zugewandten Seite eine für das Substrat geeignet angepasste erste Auflagefläche umfasst und das Gefäßoberteil auf der dem Gefäßunterteil zugewandten Seite eine für das Substrat geeignet angepasste zweite Auflagefläche umfasst, wobei die ersten und zweiten Auflageflächen und die Formen des Gefäßunterteils und des Gefäßoberteils so ausgestaltet sind, dass das zwischen den ersten und zweiten Auflageflächen positionierte Substrat flüssigkeitsdicht gehaltert werden kann, so dass die oberflächenangreifende Flüssigkeit nicht von der zu bearbeitenden Seite des Substrats auf eine andere Seite des Substrats gelangen kann und das Oberteilvolumen eine ausreichende Größe besitzt, um eine für die Bearbeitung benötigte Menge der oberflächenangreifenden Flüssigkeit aufzunehmen und während der Bearbeitung des Substrats zu speichern, wobei eine untere Grenze des Oberteilvolumen durch die zu bearbeitende Seite des Substrats gebildet wird.

Der Begriff "Gefäß" bezeichnet dabei alle Körper, in die zumindest eine oberflächenangreifende Flüssigkeit eingefüllt und über einen Zeitraum gespeichert werden kann. Für die einseitige Bearbeitung eines Substrats wird die oberflächenangreifende Flüssigkeit nur von einer Seite des Gefäßes eingefüllt und nur in dem Bereich gespeichert, der lediglich Zugang zu einer Seite des Substrats besitzt.

Der Begriff "oberflächenangreifende Flüssigkeit" bezeichnet alle Flüssigkeiten, mit denen die Oberfläche eines Substrats bearbeitet werden kann, beispielsweise eine ätzende Flüssigkeit zur Bearbeitung eines SiliziumSubstrats (Silizium-Wafers). Die Begriffe "Bearbeitung" und "bearbeiten" bezeichnen nasschemische Vorgänge, die die bearbeitete Oberfläche des Substrats verändern, beispielsweise reinigen, aufrauen, chemisch modifizieren oder auf andere Weise verändern.

Der Begriff "Substrat" bezeichnet alle Körper, die für eine nasschemische Bearbeitung an deren Oberfläche mittels einer oberflächenangreifenden Flüssigkeit vorgesehen sind. Diese Körper müssen nicht zwangsläufig scheibenförmig ausgestaltet sein, wobei der Körper im Bereich der Auflageflächen allerdings so ausgestaltet sein muss, dass er mittels aufeinander drückender Auflageflächen flüssigkeitsdicht gehaltert werden kann. Hier können die Auflageflächen der Form des Körpers entsprechend angepasst sein. In einer Ausführungsform ist das Substrat scheibenförmig ausgestaltet. In diesem Fall sind die ersten und zweiten Auflageflächen zumindest im Wesentlichen parallel zueinander angeordnet. Sofern das erfindungsgemäße Gefäß ohne Dichtringe ausgestaltet ist, sind die Auflageflächen im Falle eines scheibenförmigen Substrats planparallel zueinander angeordnet. Das Substrat kann beliebige geometrische Formen besitzen. Beispielsweise kann ein scheibenförmiges Substrat zwar eine im Wesentlichen konstante Dicke besitzen, aber in seiner Fläche kreisförmig, rechteckig, quadratisch, hexagonal oder andersförmig gestaltet sein. Das Gefäß aus Gefäßoberteil und Gefäßunterteil, insbesondere die ersten und zweiten Auflageflächen sind so gestaltet, dass das für sie vorgesehene Substrat flüssigkeitsdicht gehaltert werden kann. Bei einem kreisrunden Substrat sind die ersten und zweiten Auflageflächen vorzugsweise ebenfalls kreisrund. Das gleiche gilt analog auch für die anderen möglichen Formen des Substrats (rechteckiges Substrat - rechteckig Auflageflächen, ...).

Das Gefäßoberteil ist dazu vorgesehen, die oberflächenangreifende Flüssigkeit zur Bearbeitung des Substrats in einem Oberteilvolumen aufzunehmen. Dazu kann das gesamte Gefäßoberteil aus einem Material bestehen, das chemisch resistent gegenüber der oberflächenangreifenden Flüssigkeit ist. In einer Ausführungsform umfasst das Gefäßoberteil einen das Oberteilvolumen begrenzenden ersten Bereich, der aus einem Material gefertigt ist, dass gegenüber der oberflächenangreifenden Flüssigkeit zumindest hinreichend resistent ist, während das Gefäßoberteil außerhalb des ersten Bereichs zumindest teilweise aus einem gegenüber der oberflächenangreifenden Flüssigkeit nicht resistenten Material gefertigt ist. Hierbei erstreckt sich der erste Bereich an der dem Gefäßunterteil zugewandten Seite zumindest bis zur flüssigkeitsabdichten Stelle des Gefäßoberteils bei eingelegtem Substrat. Geeignete oberflächenangreifende Flüssigkeiten zur Bearbeitung von Substraten sind beispielsweise
a) Königswasser: 100 % HCL (Salzsäure)
   und 100 % HNO₃ (Salpetersäure), im Verhältnis 3:1;
b) Piranha , H₂SO₅ (Schwefelsäure) und H₂O₂ (Wasserstoffperoxid) im Verhältnis 1:1;
c) RCA I: Wasser (H₂O): H₂O₂: Ammoniumhydroxid (NH₄OH) im Verhältniss 1:1:1 oder RCA II: H₂O: H₂O₂: HCL im Verhältnissen 1:1:1; oder
d) 100 % HNO₃ und 40 % HF (Verhältnis 1:1).

Geeignete resistente Materialien für das Gefäßoberteil, zumindest für den ersten Bereich sind beispielsweise Polyethylen (PE) und Polypropylen (PP), die gegen viele der verwendeten oberflächenangreifenden Flüssigkeiten hinreichend resistent sind. Auch der Einsatz von Keramiken oder Metall ist möglich. Als anderes Material kann beispielsweise Quarzglas für die oberflächenangreifenden Flüssigkeiten (b) und (c) gut verwendet werden. Als besonders resistentes Material kann PTFE für alle oben genannten oberflächenangreifenden Flüssigkeiten als Material für das Gefäßoberteil beziehungsweise für den ersten Bereich verwendet werden. Der Begriff "hinreichend resistent" bezeichnet dabei ein Material, das es ermöglicht, einige hundert Substrate mit oberflächenangreifenden Flüssigkeit zu bearbeiten, bevor die Oberfläche des Oberteilvolumens selbst chemisch so angegriffen wird, dass keine ausreichende Dichtwirkung gegenüber der oberflächenangreifenden Flüssigkeit mehr gegeben ist oder die Qualität der Bearbeitung des Substrats nicht mehr akzeptabel ist. Im Idealfall ist das Material des ersten Bereichs des Gefäßoberteils chemisch so resistent, dass es durch die oberflächenangreifende Flüssigkeit nicht angegriffen wird, beispielsweise aus Quarzglas (Ausnahme Flusssäure). Ein besonders resitentes Material gegenüber den verwendeten oberflächenangreifenden Flüssigkeiten ist PTFE (Polytetrafluorethylen, gelegentlich auch Polytetrafluorethen genannt). Sofern dieses Material nicht über 200° erhitzt wird, können mehr als tausend, gegebenenfalls mehrere tausend Substratbearbeitungen vorgenommen werden, ohne dass dieses Material durch die oberflächenangreifenden Flüssigkeiten zur Substatbearbeitung selber angegriffen wird. Durch diese Aufteilung des Gefäßoberteils in einen ersten Bereich und einen oder mehrere andere Bereiche muss nur ein Teil des Gefäßoberteils aus einem teuren chemisch resistenten Material, beispielsweise PTFE, Keramik, Glas oder Metall, gefertigt werden, während der restliche Bereich des Gefäßoberteils aus einem einfachen Material, beispielsweise Harnharzstoff als einfacher Kunststoff, bestehen kann, das beispielsweise eine weniger aufwendige Spritzgussfertigung ermöglicht.

In einer Ausführungsform ist der erste Bereich reversibel im Gefäßoberteil geeignet zum Austausch gegen einen anderen ersten Bereich gehaltert. Dazu besitzt der erste Bereich eine geeignete Form, die eine reversible Halterung ermöglicht, beispielsweise eine symmetrische Form mit einem kreisförmigen Querschnitt (innen hohle Zylinderform) oder einem rechteckigen Querschnitt (innen hohle Quaderform) bei einem zylinderförmigen oder quaderförmigen Gefäßoberteil. Der Fachmann kann im Rahmen der vorliegenden Erfindung auch andere geeignete Formen des ersten Bereichs angepasst auf die Form des Gefäßoberteils wählen. Der erste Bereich kann beispielsweise durch einen Presssitz mittels ausreichender Reibungskräfte im restlichen Gefäßoberteil, das den ersten Bereich im Presssitz umgibt, gehaltert werden. Durch den austauschbaren ersten Bereich kann immer ein erster Bereich aus einem für die jeweilig angewendete oberflächenangreifende Flüssigkeit besonders geeigneten Material (besonders resistentes Material) für die nachfolgende Substratbearbeitung gewählt werden. Außerdem kann durch Austausch des ersten Bereichs vermieden werden, dass das komplette Gefäßoberteil bei einem abgenutzten ersten Bereich ausgetauscht werden müsste. Dadurch können Materialkosten vermieden und eine gute Prozessqualität bei der Substratbearbeitung gewährleistet werden.

Das Gefäßunterteil dient dabei als Träger für das Substrat, wobei die erste Auflagefläche des Gefäßunterteils in Zusammenwirkung mit der zweiten Auflagefläche und dem Substrat eine Dichtwirkung gegenüber der oberflächenangreifenden Flüssigkeit herstellt, so dass keine oberflächenangreifende Flüssigkeit auf die andere Seite des Substrats gelangen kann. Die Dichtwirkung kann dabei im Rahmen der vorliegenden Erfindung durch verschiedene Dichtmechanismen erreicht werden. Beispielsweise kann als Dichtmechanismus ein Presssitz des Gefäßoberteils auf dem Gefäßunterteil verwendet werden, bei dem die ersten und zweiten Auflageflächen aufeinandergedrückt werden (Ausüben eines Anpressdrucks), so dass das Substrat flüssigkeitsdicht umschlossen wird und das Gefäßoberteil aufgrund des Presssitzes für den Bearbeitungsvorgang in seiner Position verbleibt. Dazu müssen die Formen von Gefäßoberteil und Gefäßunterteil so aufeinander angepasst sein, dass das Gefäßoberteil mit Druck auf das Gefäßunterteil aufgeschoben werden kann. In einer alternativen Ausführungsform kann das Gefäßoberteil auch auf das Gefäßunterteil aufgeschraubt werden. Es können von Fachmann auch andere Dichtmechanismen zum Ausüben eines Anpressdrucks auf die ersten und zweiten Auflageflächen im Rahmen der vorliegenden Erfindung gewählt werden. Damit kann das Gefäß zur Bearbeitung eines Substrats schnell und mit geringem Aufwand in Betrieb genommen werden. Als andere Seite wird hier der Bereich bezeichnet, der von der oberflächenangreifenden Flüssigkeit nicht bearbeitet werden soll. Es ist daher je nach gewähltem Dichtmechanismus nicht prinzipiell ausgeschlossen, dass die oberflächenangreifende Flüssigkeit den Rand des Substrats oder die andere Seite des Substrats im Randbereich erreicht. Der Dichtmechanismus muss lediglich verhindern, dass die oberflächenangreifende Flüssigkeit die Bereiche der anderen Seite des Substrats erreicht, die nicht von der oberflächenangreifenden Flüssigkeit bearbeitet werden sollen. Nur diese Bereiche werden in der vorliegenden Erfindung als andere Seite bezeichnet. Insofern kommt das Gefäßunterteil nicht oder nur im sehr geringen Maße mit der oberflächenangreifenden Flüssigkeit in Berührung. In einer Ausführungsform umfasst dazu zumindest die erste Auflagefläche einen Dichtring. In einer anderen Ausführungsform ist der Dichtmechanismus zwischen erster und zweiter Auflagefläche so ausgestaltet, dass das Gefäßunterteil nicht mit der oberflächenangreifenden Flüssigkeit in Berührung kommt. In diesem Fall muss das Gefäßunterteil nicht aus einem Material bestehen, das chemisch resistent gegenüber der oberflächenangreifenden Flüssigkeit ist. Dadurch kann das Gefäßunterteil aus einem kostengünstigeren Material, beispielsweise einem einfachen Kunststoff wie Harnstoffharz, hergestellt sein. Dazu umfasst zumindest die erste Auflagefläche einen Dichtring oder die erste Auflagefläche und die zweite Auflagefläche umfassen beide einen Dichtring. In anderen Ausführungsformen können auch mehrere Dichtringe pro Auflagefläche verwendet werden. Vorzugsweise sind im Falle von Dichtringen in erster und zweiter Auflagefläche diese Dichtringe in Druckrichtung gesehen übereinander angeordnet, um Spannungen im Substrat während der Bearbeitung zu vermeiden und/oder die Dichtwirkung des Dichtrings in/auf der zweiten Auflagefläche noch weiter zu verstärken. Der Dichtring kann dabei jede geeignete Form besitzen, beispielsweise kann der Dichtring einen zylinderförmigen oder rechteckigen Querschnitt besitzen. Die umlaufende Form des Dichtrings ist dabei auf den zu bearbeitenden Bereich auf der einen Seite des Substrats angepasst. Je nach Form des abzuschirmenden Bereichs oder des zu bearbeitenden Bereichs des Substrats kann der Dichtring eine Kreisform, eine rechteckige oder quadratische Form oder eine andere Form besitzen.

Außerdem muss das Oberteilvolumen eine ausreichende Größe besitzen, um eine für die Bearbeitung benötigte Menge der oberflächenangreifenden Flüssigkeit aufzunehmen zu können. Bei einem Oberteilvolumen, dessen Grundfläche durch die zu bearbeitende Fläche des Substrats gegeben ist, sollte die Höhe des Volumens nicht weniger als 25mm, vorzugsweise 35mm oder in Abhängigkeit von der jeweiligen Bearbeitungsart und Bearbeitungsziel mehr betragen. Da die Höhe des Volumens der Höhe des Gefäßoberteils oberhalb der zweiten Auflagefläche entspricht, sollte somit das Gefäßoberteil eine Höhe von nicht weniger als 25mm, vorzugsweise 35mm oder mehr, besitzen. Die damit festgelegte Größe des Oberteilvolumens ist deutlich geringer, als das Volumen eines Ätzbades gemäß dem Stand der Technik, das mit entsprechender oberflächenangreifender Flüssigkeit vollständig gefüllt wird, um darin die Einkapselungen gemäß dem Stand der Technik hineinlegen zu können. Mit dem erfindungsgemäßen Gefäß und dem lediglich mit der für den Bearbeitungsprozess notwendigen Menge der oberflächenangreifenden Flüssigkeit zu befüllenden Oberteilvolumens, können bei gleichem Prozessergebnis gegenüber dem Stand der Technik bis zu 90% an oberflächenangreifender Flüssigkeit eingespart werden. Diese Einsparung ist insbesondere wichtig bei Bearbeitungsprozessen, bei denen aus Reinheitsgründen die oberflächenangreifende Flüssigkeit nur für die Bearbeitung eines einzigen Substrats benutzt werden kann. Dadurch wird der Verbrauch an oberflächenangreifender Flüssigkeit gegenüber dem Stand der Technik stark verringert.

Die Formen des Gefäßunterteils und des Gefäßoberteils können sich je nach Anwendungsbereich deutlich unterscheiden. Die Form muss allerdings so ausgestaltet sein, dass das zwischen den ersten und zweiten Auflageflächen positionierte Substrat flüssigkeitsdicht gehaltert werden kann. Der Fachmann kann im Rahmen der vorliegenden Erfindung die für das jeweilige zu bearbeitenden Substrat geeignete Form für das Gefäßunterteil und das Gefäßoberteil wählen.

In einer Ausführungsform umfasst das Gefäß ein oder mehrere Haltemittel zum Ausüben eines Anpressdrucks zumindest der ersten und zweiten Auflagenflächen auf das zwischen ihnen gehalterte Substrat. Diese Haltemittel können gegebenenfalls einen durch die Form und das Gewicht der Gefäßober-und Gefäßunterteile bereits gegebenen Anpressdruck noch weiter verstärken, um die flüssigkeitsdichte Halterung weiter zu verbessern, beispielsweise um einen Ausdehneffekt für das Gefäßoberteil, dass beispielsweise im Presssitz auf dem Gefäßunterteil sitzt, durch heiße oberflächenangreifende Flüssigkeiten oder entstehende Prozesswärme zu kompensieren. In einer bevorzugten Ausführungsform umfasst das Haltemittel ein oder mehreren Elemente aus der Gruppe Klemmen, Federn, Schraubvorrichtungen oder Spannvorrichtungen.

In einer weiteren Ausführungsform umfasst das Gefäßunterteil eine umlaufende Erhöhung mit einer Seitenfläche, deren oberer Rand die erste Auflagefläche darstellt, und das Gefäßoberteil eine umlaufende Vertiefung mit einer Seitenwand und einem tieferliegenden Rand, wobei der tieferliegende Rand die zweite Auflagefläche darstellt, wobei die Vertiefung so ausgeformt ist, dass die Seitenwand der Vertiefung übergreifend über die Erhöhung des Gefäßunterteils zur flüssigkeitsdichten Halterung des Substrats zwischen den ersten und zweiten Auflageflächen angeordnet werden kann. Durch diese Ausführungsform kann das Gefäßoberteil ortsfest zum Gefäßunterteil positioniert werden, da die Seitenwand des Gefäßoberteils an der Seitenfläche des Gefäßunterteils anliegt. Damit können sich die ersten und zweiten Auflageflächen nicht gegeneinander verschieben. Sind die Formen der Erhöhung und der Vertiefung so aufeinander angepasst, dass das Gefäßoberteil unter Ausübung eine Kraft auf das Gefäßunterteil geschoben werden muss, so kann der Anpressdruck des oberen Rands der Erhöhung des Gefäßunterteils auf den tieferliegenden umlaufenden Rand des Gefäßoberteils als erste und zweite Auflageflächen durch den resultierenden Presssitz vom Gefäßoberteil auf dem Gefäßunterteil ausgeübt werden. Dieser Presssitz kann dadurch verstärkt werden, dass die sich berührenden Teile von Gefäßoberteil und Gefäßunterteil, zumindest die Seitenwände der Erhöhung und der Vertiefung, aus einem weichen Material, beispielsweise Kunststoff, gefertigt sind und somit über Reibungseffekte besonders fest aufeinander sitzen.

In einer bevorzugten Ausführungsform besteht das Haltemittel aus einem ersten Gewinde auf der Seitenfläche der Erhöhung und aus einem entsprechend darauf angepassten Gegengewinde auf der inneren Fläche der Seitenwand der Vertiefung zur gegenseitigen Verschraubung. Über die Verschraubung kann ein definierter Anpressdruck der ersten und zweiten Auflageflächen aufeinander und gemeinsam auf das Substrat reproduzierbar eingestellt werden. Auf diese Weise lässt sich eine zuverlässige flüssigkeitsdichte Halterung des Substrats zwischen der ersten und zweiten Auflagefläche herstellen.

In einer weiteren Ausführungsform umfasst das Gefäßunterteil innerhalb der von der ersten Auflagefläche umlaufenden Fläche mindestens eine von der oberen Seite zur unteren Seite des Gefäßunterteils durchlaufende Bohrung. Da zwischen dem gehalterten Substrat und dem Gefäßunterteil immer ein gewisses (eventuell kleines) Luftvolumen eingeschlossen wird, kann sich dieses gegebenenfalls während des Bearbeitungsprozesses aufgrund der dabei möglicherweise freiwerdenden Wärme oder durch eine bereits erwärmte oberflächenangreifende Flüssigkeit erhitzen und so einen Druck auf das Substrat ausüben. Je nach Wärmeentwicklung und Größe des Luftvolumens können sich Spannungen im Substrat bilden, die gegebenenfalls das Substrat beschädigen könnten. Die Bohrung sorgt dafür, dass die sich ausdehnende Luft aus dem Volumen unterhalb des Substrats entweichen kann. Da zumindest die Unterseite des Gefäßunterteils nicht in Berührung mit der oberflächenangreifenden Flüssigkeit kommt, sind an die Bohrung keine besonderen Anforderungen gestellt. Das Gefäßunterteil wird typischerweise auf eine ebenen Unterlage gestellt, so dass die Luft einfach aus der Bohrung entlang der Unterlage entweichen kann.

In einer weiteren Ausführungsform umfasst das Gefäßunterteil zumindest in dem Bereich unterhalb des Substrates ein verschließbares Unterteilvolumen für Flüssigkeiten, das von der ersten Auflagefläche umlaufen wird und das in Richtung des Gefäßoberteils durch das auf der ersten Auflagefläche positionierte Substrat begrenzt wird. Die in das Unterteilvolumen einzufüllenden Flüssigkeiten sind keine oberflächenangreifenden Flüssigkeiten, da die zum Gefäßunterteil zeigende Seite des Substrats ("andere Seite") nicht bearbeitet werden soll (einseitige Bearbeitung des Substrats). Die in das Unterteilvolumen eingelassene Flüssigkeit kann beispielsweise das Substrat rückseitig erhitzen oder abkühlen, so dass auch längere einseitig temperierte Ätzprozesse durchgeführt werden können.

In einer bevorzugten Ausführungsform umfasst das Gefäßunterteil zumindest eine Einlassöffnung und eine Auslassöffnung, so dass die Flüssigkeiten durch das Unterteilvolumen zumindest während der Bearbeitung des Substrates durchfließen können, vorzugsweise sind die Einlassöffnung und/oder die Auslassöffnung durch mindestens ein einstellbares Ventil variabel steuerbar. Dadurch können Flüssigkeiten zu Kühl- oder Heizzwecken sehr präzise durch das Unterteilvolumen durchgeleitet werden, so dass eine bestimmte Substrattemperatur über einen langen Zeitraum sehr genau konstant gehalten werden kann. Dies ist gerade für die Steuerung der Ätzprozesse, die temperatursensitiv verlaufen, sehr wichtig.

In einer weiteren Ausführungsform umfasst das Gefäßoberteil ein Ausgießmittel, beispielsweise einen kannenähnlichen Ausguss wie eine Tülle, zum sicheren Ausgießen der oberflächenangreifenden Flüssigkeit, nach erfolgter einseitiger Bearbeitung eines Substrats, aus dem Oberteilvolumen. Dadurch wird eine Bediensicherheit gegenüber unbeabsichtigtem Verschütten der oberflächenangreifenden Flüssigkeit erreicht.

Die Erfindung betrifft des Weiteren ein Verfahren zur einseitigen Bearbeitung eines Substrats mit mindestens einer oberflächenangreifenden Flüssigkeit unter Verwendung eines Gefäßes, umfassend ein Gefäßunterteil und ein Gefäßoberteil gemäß der vorliegenden Erfindung, umfassend die Schritte:
- Positionieren des Gefäßunterteils auf einer Unterlage in einer Position, in der eine erste Auflagefläche des Gefäßunterteils von der Unterlage abgewandt ist;
- Positionieren des Substrats auf der ersten Auflagefläche;
- Flüssigkeitsdichtes Haltern des Substrats zwischen der ersten Auflagefläche und einer zweiten Auflagefläche des Gefäßoberteils, die an der Seite des Gefäßoberteils angeordnet ist, die der ersten Auflagefläche zugewandt ist, durch Bilden des Gefäßes aus dem Gefäßunterteil und dem Gefäßoberteil mittels einer geeigneten Ausgestaltung der ersten und zweiten Auflageflächen und der Formen des Gefäßunterteils und des Gefäßoberteils;
- Befüllen eines Oberteilvolumens angeordnet im Gefäßoberteil, dessen untere Begrenzung durch die zu bearbeitende Seite des Substrats gebildet wird, mit einer oberflächenangreifenden Flüssigkeit, die aufgrund der flüssigkeitsdichten Halterung nicht auf die andere Seite des Substrate gelangen kann, über zumindest eine Einfüllöffnung des Gefäßoberteils zur Bearbeitung des Substrats;
- Speichern der oberflächenangreifenden Flüssigkeit in dem Oberteilvolumen während der Bearbeitung des Substrats.

Diese Einfüllöffnung im Gefäßoberteil kann vom Fachmann im Rahmen der vorliegenden Erfindung geeignet ausgestaltet werden. Beispielsweise ist das Gefäßoberteil innen hohl ausgeführt, so dass die Einfüllöffnung der gesamte Bereich der Oberseite des Gefäßoberteils innerhalb eines umlaufenden Rands ist.

In einer Ausführungsform umfasst das Verfahren den weiteren Schritt des Befüllens eines im Gefäßunterteil in dem Bereich unterhalb des Substrates befindlichen Unterteilvolumens, das von der ersten Auflagefläche umlaufen wird und das in Richtung des Gefäßoberteils durch das auf der ersten Auflagefläche positionierte Substrat begrenzt wird, zumindest während des Bearbeitens des Substrats mit einer Flüssigkeit (andere oder zweite Flüssigkeit), die keine oberflächenangreifende Flüssigkeit ist

In einer Ausführungsform umfasst das Verfahren den weiteren Schritt des Durchspülens des Unterteilvolumens mit der Flüssigkeit, wozu der Gefäßunterteil eine Einlassöffnung in das Unterteilvolumen und eine Auslassöffnung aus dem Unterteilvolumen umfasst.

In einer weiteren Ausführungsform des Verfahrens wird die Bearbeitung des Substrats durch Ausgießen der oberflächenangreifenden Flüssigkeit aus dem Oberteilvolumen beendet. Da sich die oberflächenangreifende Flüssigkeit lediglich im Oberteilvolumen befindet, nicht aber mit der äußeren Oberfläche von Gefäßoberteil und Gefäßunterteil in Berührung kommt, kann das Ausgießen auch manuell ohne weitere Schutzmaßnahmen erfolgen, was die Handhabung des Bearbeitungsprozesses stark vereinfacht.

### Kurze Beschreibung der Abbildungen

Diese und andere Aspekte der Erfindung werden im Detail in den Abbildungen wie folgt gezeigt:
- Fig.1:: eine Ausführungsform des erfindungsgemäßen Gefäßes im seitlichen Schnitt mit (a) getrennten Gefäßoberteil und Gefäßunterteil und (b) das gebildete Gefäß mit flüssigkeitsdicht gehalterten Substrat;
- Fig.2:: Ausführungsformen des erfindungsgemäßen Gefäßes mit Haltemitteln in Form (a) einer Klammervorrichtung und (b) eines Schnappverschlusses;
- Fig.3:: verschiedene Ausführungsformen des Gefäßes in Draufsicht von oben mit (a) quadratischem Querschnitt, (b) kreisrundem Querschnitt, (c) rechteckigem Querschnitt und (d) hexagonalem Querschnitt;
- Fig.4:: eine perspektivische Ansicht einer Ausführungsform des erfindungsgemäßen Gefäßes, wobei Gefäßoberteil und Gefäßunterteil über entsprechende Gewinde miteinander verschraubbar sind;
- Fig.5:: eine Ausführungsform des Gefäßunterteils mit Bohrungen zur Entlüftung des Volumens unterhalb des Substrats;
- Fig.6:: eine Ausführungsform des Gefäßunterteils mit einem Unterteilvolumen zum Befüllung und Durchspülen mit einer Flüssigkeit, die das Substrat nicht angreift;
- Fig.7:: eine Ausführungsform des Gefäßoberteils mit einem ersten Bereich aus einem chemisch resistenten Material, (a) im seitlichen Schnitt und (b) in Draufsicht von oben;
- Fig.8:: eine Ausführungsform des Gefäßoberteils mit einem Ausgießmittel, (a) im seitlichen Schnitt und (b) in Draufsicht von oben;
- Fig.9:: eine Ausführungsform eines erfindungsgemäßen Verfahrens zur einseitigen Bearbeitung eines Substrats mit dem erfindungsgemäßen Gefäß.

### Detaillierte Beschreibung der Ausführungsbeispiele

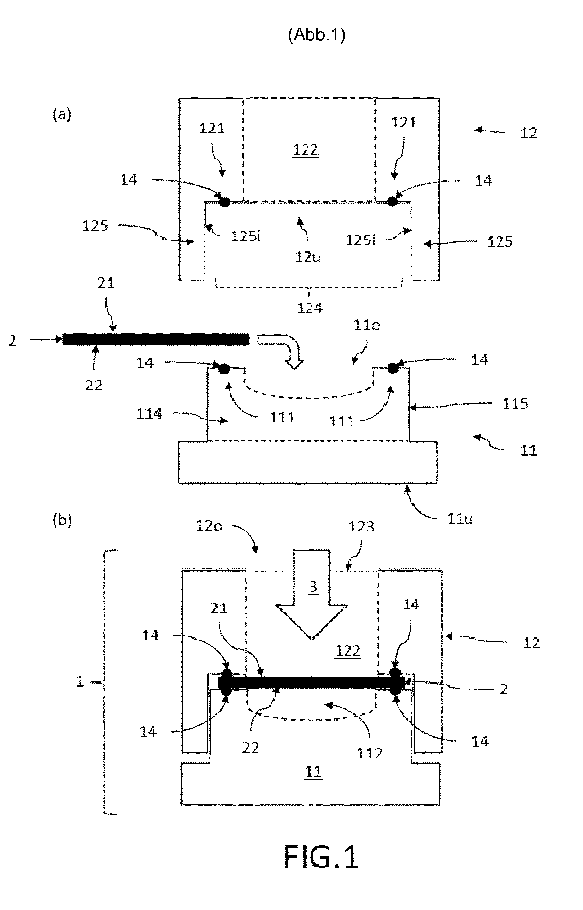

Fig.1 zeigt eine Ausführungsform des erfindungsgemäßen Gefäßes 1 im seitlichen Schnitt mit (a) getrennten Gefäßoberteil 12 und Gefäßunterteil 11 und (b) das gebildete Gefäß 1 mit flüssigkeitsdicht gehaltertem Substrat 2 zur einseitigen Bearbeitung BA eines Substrats 1. Das Gefäßoberteil 12 umfasst ein Oberteilvolumen 122 zur Aufnahme einer oberflächenangreifenden Flüssigkeit 3 zur Bearbeitung des Substrats 2. Dieses Substrat 2 wird in (a) auf das Gefäßunterteil 11 gelegt (angedeutet durch Pfeil). Das Gefäßoberteil 12 umfasst mindestens eine Einfüllöffnung 123 für das Oberteilvolumen 122 zum Einfüllen der oberflächenangreifenden Flüssigkeit 3 in das Gefäßoberteil 12. Das Gefäßunterteil 11 umfasst auf der dem Gefäßoberteil 12 zugewandten Seite 11 o eine für das Substrat 2 (hier ein scheibenförmiges Substrat) geeignet angepasste erste Auflagefläche 111 (ebene Fläche parallel zu den Seiten des Substrats). Entsprechend umfasst das Gefäßoberteil 12 auf der dem Gefäßunterteil 11 zugewandten Seite 12u eine für das Substrat 2 geeignet angepasste zweite Auflagefläche 121, wobei die ersten und zweiten Auflageflächen 111, 121 und die Formen des Gefäßunterteils 11 und des Gefäßoberteils 12 so ausgestaltet sind, dass das zwischen den ersten und zweiten Auflageflächen 111, 121 positionierte Substrat 2 flüssigkeitsdicht gehaltert H werden kann, so dass die oberflächenangreifende Flüssigkeit 3 nicht von der zu bearbeitenden Seite 21 des Substrats 2 auf eine andere Seite 22 des Substrats 2 gelangen kann, wie in Teil (b) von Figur 1 gezeigt ist. Für die flüssigkeitsdichte Halterung umfassen in dieser Ausführungsform sowohl die erste Auflagefläche 111 als auch die zweite Auflagefläche 121 einen Dichtring 14, wobei die Dichtringe 14 in Richtung des Anpressdrucks übereinander angeordnet sind, um Spannungen auf das Substrat (2) zu vermeiden. Außerdem umfasst das Gefäßunterteil 11 eine umlaufende Erhöhung 114 mit einer Seitenfläche 115, dessen oberer Rand 111 die erste Auflagefläche 111 darstellt. Damit beide Teile 11, 12 verrutschungssicher aufeinander passen, umfasst das Gefäßoberteil 12 eine umlaufende Vertiefung 124 mit einer Seitenwand 125 und einem tieferliegenden Rand 121, wobei der tieferliegende Rand 121 die zweite Auflagefläche 121 darstellt. Für beispielsweise einen flüssigkeitsdichten Presssitz von Gefäßoberteil 12 auf dem Gefäßunterteil 11 ist die Vertiefung 124 so ausgeformt, dass die Seitenwand 125 der Vertiefung 124 mit der Innenseite 125i der Seitenwand 125 in Kontakt zu der Seitenfläche 115 der Erhöhung 114 über die Erhöhung 114 des Gefäßunterteils 11 mit einer den Presssitz sichernden Kraftanstrengung geschoben werden muss. Damit wird ein fester Preesitz erreicht und aufgrund des dadurch bewirkten konstanten Anpressdrucks das Substrat 2 zwischen den ersten und zweiten Auflageflächen 111, 121 flüsssigkeitsdicht gehaltert. Für die anschließende Bearbeitung besitzt das Oberteilvolumen 122 eine ausreichende Größe, um eine für die Bearbeitung benötigte Menge der oberflächenangreifenden Flüssigkeit 3 aufzunehmen und während der Bearbeitung BA des Substrats 2 zu speichern S, wobei die untere Grenze des Oberteilvolumen 122 durch die zu bearbeitende Seite 21 des Substrats 2 gebildet wird, damit die oberflächenangreifende Flüssigkeit 3 nach dem Einfüllen auch in Kontakt mit er zu bearbeitenden Seite 21 des Substrats 2 gelangt. Die andere Seite 22 des Substrats 2 bleibt dagegen unbearbeitet. Da das Gefäßunterteil 11 nicht in Berührung mit der oberflächenangreifenden Flüssigkeit gelangt, kann das Gefäßunterteil 11 aus einem beliebigen geeigneten Material, zum Beispiel Kunststoff, gefertigt werden. Es müssen hier keine chemisch gegen oberflächenangreifende Flüssigkeiten resistenten Materialien verwendet werden. Dagegen kommt zumindest der Bereich des Gefäßoberteils 12, der das Oberteilvolumen 122 begrenzt, mit der oberflächenangreifenden Flüssigkeit 3 in Kontakt, so dass zu mindestens dieser Bereich des Gefäßoberteils 12 aus chemisch gegen die oberflächenangreifende Flüssigkeit 3 resistenten Material, beispielsweise PTFE, Keramik, Glas oder Metall, gefertigt werden muss.

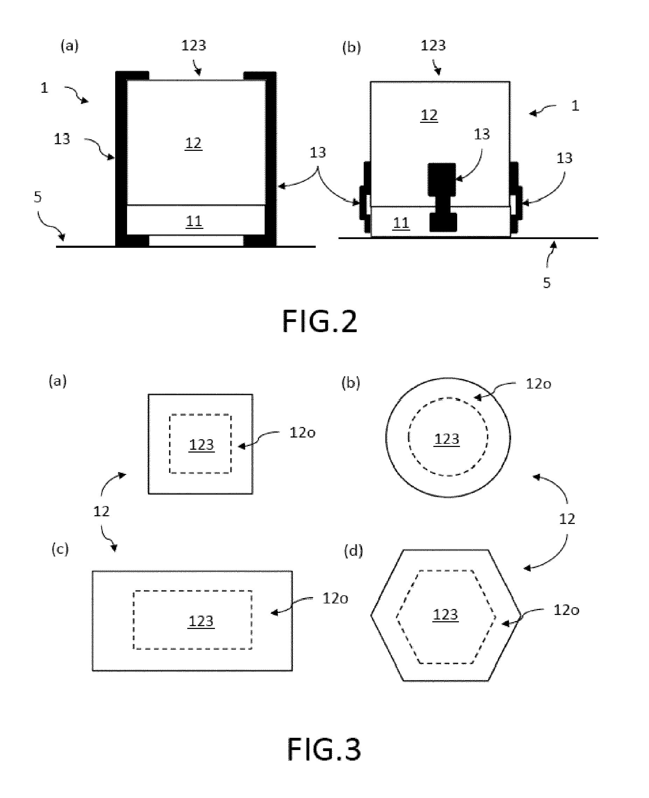

Fig.2 zeigt Ausführungsformen des erfindungsgemäßen Gefäßes mit Haltemitteln in Form (a) einer Klammervorrichtung 13 und (b) eines Schnappverschlusses 13 als unterschiedliche Ausführungsformen von Haltemitteln 13. Die Haltemittel 13 dienen zum Ausüben oder Verstärken eines Anpressdrucks der ersten und zweiten Auflagenflächen 111, 121 auf das zwischen ihnen gehalterte Substrat 2. Das Haltemittel 13 kann vom Fachmann im Rahmen der vorliegenden Erfindung geeignet gewählt werden und kann ein oder mehrere Elemente aus der Gruppe Klemmen, Federn, Schraubvorrichtungen oder Spannvorrichtungen umfassen.

Fig.3 zeigt verschiedene Ausführungsformen des Gefäßes in Draufsicht von oben mit (a) quadratischem Querschnitt, (b) kreisrundem Querschnitt, (c) rechteckigem Querschnitt und (d) hexagonalem Querschnitt. Das Gefäß beziehungsweise die Gefäßober- und/oder Gefäßunterteile werden dabei in ihrer Form auf die zu bearbeitenden Substrate angepasst. Bei runden Substraten werden vorzugsweise entsprechende runde Gefäße oder bei rechteckigen Substraten entsprechend vorzugsweise rechteckige Gefäße verwendet. Analog gilt das für alle möglichen Formen eines Substrates.

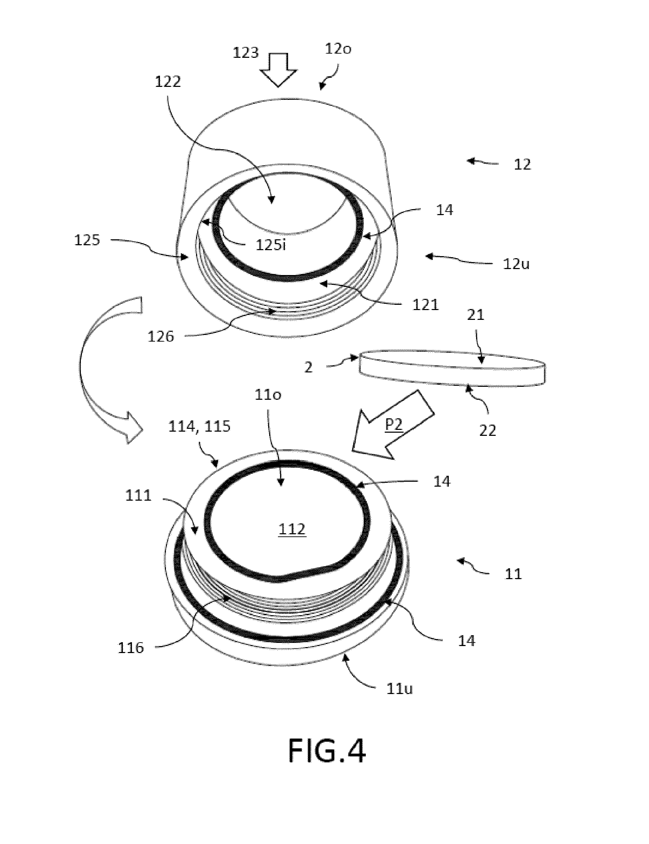

Fig.4 zeigt eine perspektivische Ansicht einer Ausführungsform des erfindungsgemäßen Gefäßes 1, wobei Gefäßoberteil 12 und Gefäßunterteil 11 über entsprechende Gewinde 116, 126 miteinander verschraubbar sind. Die Gewinde stellen Haltemittel 13 aus einem ersten Gewinde 116 auf der Seitenfläche 115 der Erhöhung 114 und aus einem entsprechend darauf angepassten Gegengewinde 126 auf der inneren Fläche 125i der Seitenwand 125 der Vertiefung 124 zur gegenseitigen Verschraubung dar. Mit einem solchen Schraubgewinde 116, 126 kann das Substrat 2 zwischen den ersten und zweiten Auflageflächen mit einem definierten und reproduzierbaren Anpressdruck flüssigkeitsdicht gehaltert werden. Vor der Verschraubung wird das Substrat 2 auf der ersten Auflagefläche 111 positioniert P2. Danach wird das Gefäßoberteil 12 auf das Gefäßunterteil 11 über die Gewinde 116, 126 geschraubt. In dieser Ausführungsform umfasst das Gefäßunterteil 11 im Bereich unterhalb des Substrates 2 ein nach unten geschlossenes Unterteilvolumen 112, das von der ersten Auflagefläche 111 umlaufen wird und das in Richtung des Gefäßoberteils 12 durch das auf der ersten Auflagefläche 111 positionierte Substrat 2 begrenzt wird. In das Unterteilvolumen 112 können beispielsweise chemisch neutrale Flüssigkeiten 4 zu Heiz- oder Kühlzwecke zur Unterstützung des Bearbeitungsprozesses für die Seite 21 des Substrats gefüllt werden.

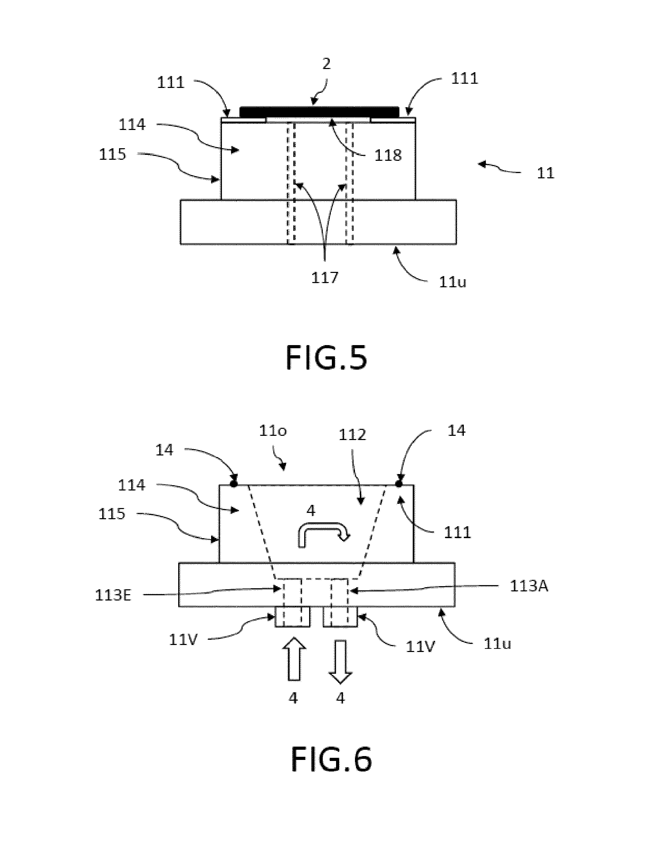

Fig.5 zeigt eine Ausführungsform des Gefäßunterteils 11 mit zwei Bohrungen 117 zur Entlüftung des Volumens 118 unterhalb des Substrats 2. Die beiden Bohrung 117 laufen von der oberen Seite 11o des Gefäßunterteils 11 zur unteren Seite 11 u des Gefäßunterteils 11 durch. Da diese Bohrungen 117 lediglich Entlüftungsbohrungen sind, sind an ihre Form und Ausgestaltung keine besonderen Anforderungen gesetzt. Der Fachmann kann die Bohrungen 117 auf eine geeignete Art herstellen und eine geeignete Anzahl an Bohrungen 117 herstellen. In einer anderen Ausführungsform kann auch nur eine einzige Bohrung 117 die obere Seite 11o mit der unteren Seite 11 u des Gefäßunterteile zur Entlüftung des Volumens 118 verbinden.

Fig.6 zeigt eine Ausführungsform des Gefäßunterteils 11 mit einem Unterteilvolumen 112 zum Befüllung und Durchspülen mit einer Flüssigkeit 4, die das Substrat nicht angreift, beispielsweise eine chemisch neutrale Flüssigkeit 4 wie Wasser. Das Gefäßunterteil 11 umfasst hier eine Einlassöffnung 11 E und eine Auslassöffnung 11A, so dass die Flüssigkeit 4 durch das Unterteilvolumen 112 während der Bearbeitung des Substrates 2 durchfließen kann. Außerdem sind hier die Einlassöffnung 11 E und die Auslassöffnung 11A durch jeweils einstellbare Ventile 11V variabel steuerbar. So kann beispielsweise die Prozesstemperatur des Substrates 2 bei der Bearbeitung der Seite 21 sehr präzise auf einer Solltemperatur gehalten werden.

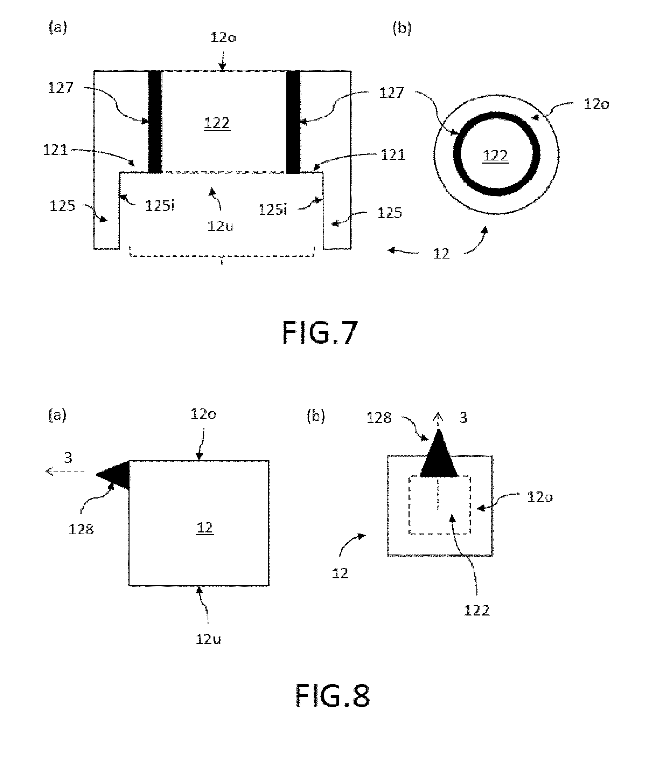

Fig.7 zeigt eine Ausführungsform des Gefäßoberteils 12 mit einem ersten Bereich 127 aus einem chemisch resistenten Material, (a) im seitlichen Schnitt und (b) in Draufsicht von oben. Der erste Bereich 127 ist dabei aus einem Material gefertigt, das gegenüber der oberflächenangreifenden Flüssigkeit 3 zumindest hinreichend resistent ist, während das Gefäßoberteil 12 außerhalb des ersten Bereichs 127 zumindest teilweise aus einem gegenüber der oberflächenangreifenden Flüssigkeit 3 nicht resistenten Material gefertigt ist. Hierbei erstreckt sich der erste Bereich 127 an der dem Gefäßunterteil zugewandten Seite 12u zumindest bis zur flüssigkeitsabdichten Stelle des Gefäßoberteils 12 bei eingelegtem Substrat 2. Somit können die Materialkosten für die Herstellung des Gefäßoberteils 12 durch die ermöglichte teilweise Verwendung von kostengünstigeren Materialien verringert werden. In einer Ausführungsform ist der erste Bereich 127 reversibel im Gefäßoberteil 12 geeignet zum Austausch gegen einen anderen ersten Bereich 127 gehaltert. Dazu besitzt der erste Bereich 127 in diesem Ausführungsbeispiel eine innen hohle Zylinderform (schwarz im seitlichen Schnitt dargestellt), die in dem ebenfalls zylinderförmigen den ersten Bereich 127 umgebenden restlichen Gefäßoberteil 12 mittels Presssitz aufgrund ausreichender Reibungskräfte gehaltert ist. Der Fachmann kann im Rahmen der vorliegenden Erfindung auch andere geeignete Formen des ersten Bereichs 127 angepasst auf die Form des Gefäßoberteils 12 wählen. Durch den austauschbaren ersten Bereich 127 kann immer ein erster Bereich 127 aus einem für die jeweilig angewendete oberflächenangreifende Flüssigkeit besonders geeigneten Material (besonders resistentes Material) für die nachfolgende Substratbearbeitung gewählt werden. Außerdem kann durch Austausch des ersten Bereichs 127 vermieden werden, dass das komplette Gefäßoberteil 12 bei einem abgenutzten ersten Bereich 127 ausgetauscht werden müsste. Dadurch können Materialkosten vermieden und eine gute Prozessqualität bei der Substratbearbeitung gewährleistet werden.

Fig.8 zeigt eine Ausführungsform des Gefäßoberteils mit einem Ausgießmittel, (a) im seitlichen Schnitt und (b) in Draufsicht von oben. Das Ausgießmittel 128 dient zum sicheren Ausgießen der oberflächenangreifenden Flüssigkeit 3 nach erfolgter einseitiger Bearbeitung eines Substrats 1 aus dem Oberteilvolumen 122. Der Fachmann kann im Rahmen der vorliegenden Erfindung die Form des Ausgießmittels 128 geeignet wählen, beispielsweise in Form eine Tülle oder eines Ausgießkanals. Dadurch kann eine manuelle Handhabung des Gefäßes 1 erleichtert und dennoch sicher gestaltet werden.

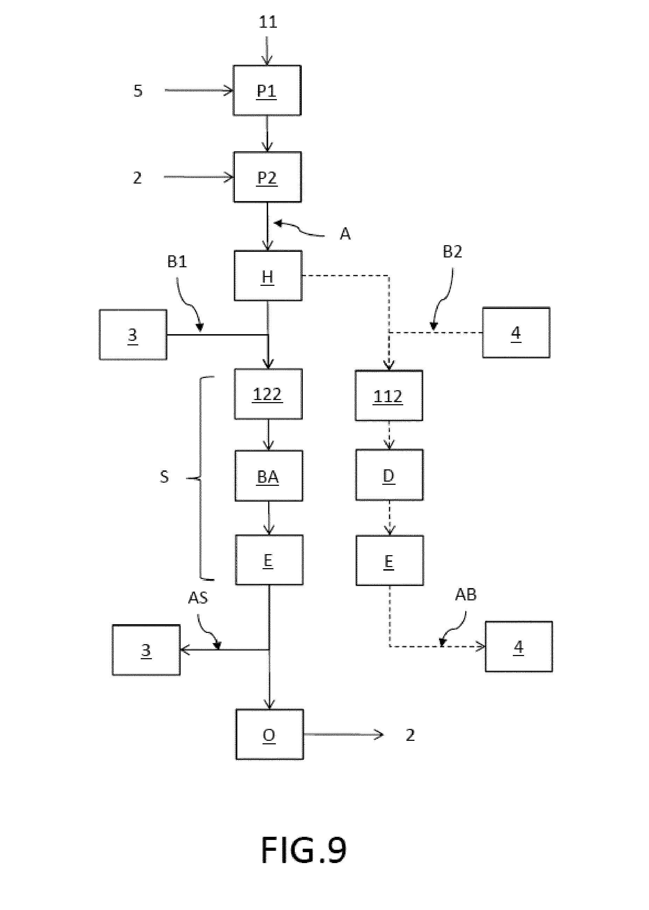

Fig.9 zeigt eine Ausführungsform eines erfindungsgemäßen Verfahrens zur einseitigen Bearbeitung BA eines Substrats 2 mit dem erfindungsgemäßen Gefäß 1. Das Verfahren umfasst dabei die Schritte des Positionierens P1 des Gefäßunterteils 11 auf einer Unterlage 5 in einer Position, in der eine erste Auflagefläche 111 des Gefäßunterteils 11 von der Unterlage (5) abgewandt ist, des Positionierens P2 des Substrats 2 auf der ersten Auflagefläche, des flüssigkeitsdichten Halterns H des Substrats 2 zwischen der ersten Auflagefläche 111 mittels Ausüben eines Anpressdrucks A aufgrund einer geeigneten Ausgestaltung der ersten und zweiten Auflageflächen (111, 121) und der Formen des Gefäßunterteils (11) und des Gefäßoberteils (12), des Befüllens B1 eines Oberteilvolumens 122, angeordnet im Gefäßoberteil 12, dessen untere Begrenzung durch die zu bearbeitende Seite des Substrats 2 gebildet wird, mit einer oberflächenangreifenden Flüssigkeit 3, die aufgrund der vorher erreichten flüssigkeitsdichten Halterung H nicht auf die andere Seite 22 des Substrate 2 gelangen kann, über zumindest eine Einfüllöffnung 123 des Gefäßoberteils 12 zur Bearbeitung BA des Substrats 2, wobei die oberflächenangreifende Flüssigkeit 3 im Oberteilvolumen 122 während der Bearbeitung BA des Substrats gespeichert wird. Simultan zu der Bearbeitung BA des Substrats 2 wird im Verfahren in dieser Ausführungsform ein im Gefäßunterteil 11 in dem Bereich unterhalb des Substrates 2 befindlichen Unterteilvolumens 112 befüllt B2, wobei das Gefäßunterteil 11 eine Einlassöffnung 11 E in das Unterteilvolumen 112 und eine Auslassöffnung 11A aus dem Unterteilvolumen 112 umfasst, so dass die Flüssigkeit 4 das Unterteilvolumen 112 während der Bearbeitung BA des Substrats 2 durchströmen D kann. Die Bearbeitung BA des Substrats 2 wird nach Erreichen des gewünschten Ergebnisses durch Ausgießen AS der oberflächenangreifenden Flüssigkeit 3 aus dem Oberteilvolumen 12 beendet (E). Anschließend wird das Gefäß 1 geöffnet O und das fertig bearbeitete Substrat 2 aus dem Gefäß 1 entnommen.

Die hier gezeigten Ausführungsformen stellen nur Beispiele für die vorliegende Erfindung dar und dürfen daher nicht einschränkend verstanden werden. Alternative durch den Fachmann in Erwägung gezogene Ausführungsformen sind gleichermaßen vom Schutzbereich der vorliegenden Erfindung umfasst.

### Liste der Bezugszeichen

- 1: Gefäß
- 11: Gefäßunterteil
- 11o: die dem Gefäßoberteil zugewandte Seite des Gefäßunterteils
- 11u: untere Seite des Gefäßunterteils (gegenüber der oberen Seite)
- 111: erste Auflagefläche
- 112: (verschließbares) Unterteilvolumen
- 113E: Einlassöffnung
- 113A: Auslassöffnung
- 11V: Ventile für Einlass- und/oder Auslassöffnung
- 114: umlaufende Erhöhung
- 115: Seitenwand der umlaufenden Erhöhung
- 116: erstes Gewinde auf der Seitenfläche der Erhöhung
- 117: durchlaufende Bohrung
- 118: Volumen unterhalb des Substrats
- 12: Gefäßoberteil
- 12u: die dem Gefäßunterteil zugewandte Seite des Gefäßoberteils
- 12o: obere Seite des Gefäßoberteils (gegenüber 12u)
- 121: zweite Auflagefläche
- 122: Oberteilvolumen
- 123: Einfüllöffnung für Oberteilvolumen
- 124: umlaufende Vertiefung
- 125: Seitenwand der umlaufenden Vertiefung
- 125i: innere Fläche der Seitenwand der Vertiefung
- 126: Gegengewinde auf der Seitenwand der umlaufenden Vertiefung
- 127: erster Bereich des Gefäßoberteils (Innenseite zum Oberteilvolumen)
- 128: Ausgießmittel
- 13: Haltemittel
- 14: Dichtring
- 2: Substrat
- 21: eine Seite des Substrats (obere Seite)
- 22: die andere Seite des Substrats (untere Seite)
- 3: oberflächenangreifende Flüssigkeit
- 4: andere Flüssigkeiten
- 5: Unterlage

- A: Ausübens eines Anpressdrucks
- AB: Ablassen der anderen Flüssigkeit 4 aus dem Unterteilvolumen
- AS: Ausgießen der oberflächenangreifenden Flüssigkeit aus dem Oberteilvolumen
- B1: Befüllen eines Oberteilvolumens mit einer oberflächenangreifenden Flüssigkeit
- B2: Befüllen des Unterteilvolumens
- BA: Bearbeiten des Substrats
- D: Durchspülens des Unterteilvolumens mit der anderen Flüssigkeit 4
- E: Beenden der Bearbeitung des Substrats
- H: Flüssigkeitsdichtes Haltern des Substrats zwischen der ersten Auflagefläche und einer zweiten Auflagefläche
- O: Öffnen des Gefäßes durch Abnehmen des Gefäßoberteils
- P1: Positionieren des Gefäßunterteils auf einer Unterlage
- P2: Positionieren des Substrats auf der ersten Auflagefläche
- S: Speichern der oberflächenangreifenden Flüssigkeit im Oberteilvolumen

## Patentansprüche

1. Ein Gefäß (1) zur einseitigen Bearbeitung (BA) eines Substrats (1) mit einem Gefäßunterteil (11) und einem auf dem Gefäßunterteil (11) zur Halterung des Substrates (2) angeordneten Gefäßoberteil (12), wobei das Gefäßoberteil ein Oberteilvolumen (122) zur Aufnahme einer oberflächenangreifenden Flüssigkeit (3) zur Bearbeitung des Substrats umfasst, die über mindestens eine Einfüllöffnung (123) im Gefäßoberteil in das Oberteilvolumen (122) eingelassen werden kann (12), wobei das Gefäßunterteil (11) auf der dem Gefäßoberteil (12) zugewandten Seite (11o) eine für das Substrat (2) geeignet angepasste erste Auflagefläche (111) umfasst und das Gefäßoberteil (12) auf der dem Gefäßunterteil (11) zugewandten Seite (12u) eine für das Substrat (2) geeignet angepasste zweite Auflagefläche (121) umfasst, wobei die ersten und zweiten Auflageflächen (111, 121) und die Formen des Gefäßunterteils (11) und des Gefäßoberteils (12) so ausgestaltet sind, dass das zwischen den ersten und zweiten Auflageflächen (111, 121) positionierte Substrat (2) flüssigkeitsdicht gehaltert (H) werden kann, so dass die oberflächenangreifende Flüssigkeit (3) nicht von der zu bearbeitenden Seite (21) des Substrats (2) auf eine andere Seite (22) des Substrats (2) gelangen kann und das Oberteilvolumen eine ausreichende Größe besitzt, um eine für die Bearbeitung benötigte Menge der oberflächenangreifenden Flüssigkeit (3) aufzunehmen und während der Bearbeitung (BA) des Substrats (2) zu speichern (S), wobei eine untere Grenze des Oberteilvolumen (122) durch die zu bearbeitende Seite (21) des Substrats (2) gebildet wird.

2. Das Gefäß (1) nach Anspruch 1,
**dadurch gekennzeichnet,**
**dass** das Gefäßoberteil (12) einen das Oberteilvolumen (122) begrenzenden ersten Bereich (127) umfasst, der aus einem Material gefertigt ist, dass gegenüber der oberflächenangreifenden Flüssigkeit (3) zumindest hinreichend resistent ist, während das Gefäßoberteil (12) außerhalb des ersten Bereichs (127) zumindest teilweise aus einem gegenüber der oberflächenangreifenden Flüssigkeit (3) nicht resistenten Material gefertigt ist.

3. Das Gefäß (1) nach Anspruch 2,
**dadurch gekennzeichnet,**
**dass** der erste Bereich (127) mit einer geeigneten Form reversible im Gefäßoberteil (12) geeignet zum Austausch gegen einen enderen ersten Bereich (127) gehaltert ist.

4. Das Gefäß (1) nach einem der voranstehenden Ansprüche,
**dadurch gekennzeichnet,**
**dass** das Gefäß (1) ein oder mehrere Haltemittel (13) zum Ausüben eines Anpressdrucks zumindest der ersten und zweiten Auflagenflächen (111, 121) auf das zwischen ihnen gehalterte Substrat (2) umfasst.

5. Das Gefäß (1) nach einem der voranstehenden Ansprüche,
**dadurch gekennzeichnet,**
**dass** das Gefäßunterteil (11) eine umlaufende Erhöhung (114) mit einer Seitenfläche (115) umfasst, dessen oberer Rand (111) die erste Auflagefläche (111) darstellt, und dass das Gefäßoberteil (12) eine umlaufende Vertiefung (124) mit einer Seitenwand (125) und einem tieferliegenden Rand (121) umfasst, wobei der tieferliegende Rand (121) die zweite Auflagefläche (121) darstellt, und die Vertiefung (124) so ausgeformt ist, dass die Seitenwand (125) der Vertiefung (124) übergreifend über die Erhöhung (114) des Gefäßunterteils (11) zur flüssigkeitsdichten Halterung des Substrats (2) zwischen den ersten und zweiten Auflageflächen (111, 121) angeordnet werden kann.

6. Das Gefäß (1) nach Anspruch 5,
**dadurch gekennzeichnet,**
**dass** das Haltemittel (13) aus einem ersten Gewinde (116) auf der Seitenfläche (115) der Erhöhung (114) und aus einem entsprechend darauf angepassten Gegengewinde (126) auf der inneren Fläche (125i) der Seitenwand (125) der Vertiefung (124) zur gegenseitigen Verschraubung besteht.

7. Das Gefäß (1) nach einem der vorangehenden Ansprüche,
**dadurch gekennzeichnet,**
**dass** die erste Auflagefläche (111) und/oder die zweite Auflagefläche (121) zumindest einen Dichtring (14) umfasst.

8. Das Gefäß (1) nach einem der vorangehenden Ansprüche,
**dadurch gekennzeichnet,**
**dass** das Gefäßunterteil (11) innerhalb der von der ersten Auflagefläche (111) umlaufenden Fläche mindestens eine von der oberen Seite (11o) zur unteren Seite (11 u) des Gefäßunterteils (11) durchlaufende Bohrung (117) umfasst.

9. Das Gefäß (1) nach einem der vorangehenden Ansprüche,
**dadurch gekennzeichnet,**
**dass** das Gefäßunterteil (11) zumindest in dem Bereich unterhalb des Substrates (2) ein verschließbares Unterteilvolumen (112) für Flüssigkeiten (4) umfasst, das von der ersten Auflagefläche (111) umlaufen wird und das in Richtung des Gefäßoberteils (12) durch das auf der ersten Auflagefläche (111) positionierte Substrat (2) begrenzt wird.

10. Das Gefäß (1) nach Anspruch 8,
**dadurch gekennzeichnet,**
**dass** das Gefäßunterteil (11) zumindest eine Einlassöffnung (11E) und eine Auslassöffnung (11A) umfasst, so dass die Flüssigkeiten (4) durch das Unterteilvolumen (112) zumindest während der Bearbeitung des Substrates (2) durchfließen können, vorzugsweise sind die Einlassöffnung (11E) und/oder die Auslassöffnung (11A) durch mindestens ein einstellbares Ventil (11V) variabel steuerbar.

11. Das Gefäß (1) nach einem der voranstehenden Ansprüche,
**dadurch gekennzeichnet,**
**dass** das Gefäßoberteil (12) ein Ausgießmittel (128) zum sicheren Ausgießen der oberflächenangreifenden Flüssigkeit (3) nach erfolgter einseitiger Bearbeitung eines Substrats (1) aus dem Oberteilvolumen (122) umfasst.

12. Ein Verfahren zur einseitigen Bearbeitung (BA) eines Substrats (2) mit mindestens einer oberflächenangreifenden Flüssigkeit (3) unter Verwendung eines Gefäßes (1), umfassend ein Gefäßunterteil (11) und ein Gefäßoberteil (12) nach Anspruch 1, umfassend die Schritt:
- Positionieren (P1) des Gefäßunterteils (11) auf einer Unterlage (5) in einer Position, in der eine erste Auflagefläche (111) des Gefäßunterteils (11) von der Unterlage (5) abgewandt ist;
- Positionieren (P2) des Substrats (2) auf der ersten Auflagefläche;
- Flüssigkeitsdichtes Haltern (H) des Substrats (2) zwischen der ersten Auflagefläche (111) und einer zweiten Auflagefläche (112) des Gefäßoberteils (12), die an der Seite (11u) des Gefäßoberteils (12) angeordnet ist, die der ersten Auflagefläche (111) zugewandt ist, durch Bilden des Gefäßes (1) aus dem Gefäßunterteil (11) und dem Gefäßoberteil (12) mittels einer geeigneten Ausgestaltung der ersten und zweiten Auflageflächen (111, 121) und der Formen des Gefäßunterteils (11) und des Gefäßoberteils (12);
- Befüllen (B1) eines Oberteilvolumens (122) angeordnet im Gefäßoberteil (12), dessen untere Begrenzung durch die zu bearbeitende Seite des Substrats (2) gebildet wird, mit einer oberflächenangreifenden Flüssigkeit (3), die aufgrund der flüssigkeitsdichten Halterung (H) nicht auf die andere Seite (22) des Substrate (2) gelangen kann, über zumindest eine Einfüllöffnung (123) des Gefäßoberteils (12) zur Bearbeitung des Substrats (2);
- Speichern (S) der oberflächenangreifenden Flüssigkeit (3) in dem Oberteilvolumen (122) während der Bearbeitung (BA) des Substrats.

13. Das Verfahren nach Anspruch 12, wobei das Verfahren den weiteren Schritt des Befüllens (B2) eines im Gefäßunterteil (11) in dem Bereich unterhalb des Substrates (2) befindlichen Unterteilvolumens (112), das von der ersten Auflagefläche (111) umlaufen wird und das in Richtung des Gefäßoberteils (12) durch das auf der ersten Auflagefläche (111) positionierte Substrat (2) begrenzt wird, zumindest während des Bearbeitens (BA) des Substrats (2) mit einer Flüssigkeit (4), die keine oberflächenangreifende Flüssigkeit ist, umfasst.

14. Das Verfahren nach Anspruch 13, wobei das Verfahren den weiteren Schritt des Durchspülens (D) des Unterteilvolumens mit der Flüssigkeit (4) umfasst, wozu der Gefäßunterteil (11) eine Einlassöffnung (11E) in das Unterteilvolumen (112) und eine Auslassöffnung (11A) aus dem Unterteilvolumen (112) umfasst.

15. Das Verfahren nach einem der Ansprüche 12 bis 14, wobei die Bearbeitung (BA) des Substrats (2) durch Ausgießen (AS) der oberflächenangreifenden Flüssigkeit (3) aus dem Oberteilvolumen (12) beendet (E) wird.
